# EUROPEAN PATENT APPLICATION

(11) **EP 2 343 398 A1**
(43) Date of publication of application: **13.07.2011**
(21) Application number: 10196522.6
(22) Date of filing: 22.12.2010
(51) Int. Cl.: C23C 16/48, C23C 16/54, C03C 25/22

(54) **Process and apparatus for continuous coating of fibrous materials**

(30) Priority: 08.01.2010 US 684305
(71) Applicant: General Electric Company, Schenectady, NY 12345 (US)
(72) Inventor: Brun, Milivoj Konstantin, Niskayuna, NY 12309 (US); Luthra, Krisham Lal, Niskayuna, NY 12309 (US); Sommerer, Timothy John, Niskayuna, NY 12309 (US); Michael, Joseph Darryl, Niskayuna, NY 12309 (US); Minnear, William Paul, Niskayuna, NY 12309 (US)
(74) Representative: Szary, Anne Catherine

(57) **Abstract**

A process and apparatus (50) for continuously depositing a coating on a fibrous material. The process is a chemical vapor deposition process that includes causing multiple strands (46) of a fibrous material to continuously travel through a coating zone within an enclosed chamber (44) defined by a housing (42) so that portions of the strands (46) contact a reactant gas as the portions travel through the chamber (44), directly heating the portions of the strands (46) without physically contacting the strands (46) and without directly heating the housing (42), and depositing a coating material on the strands (46) as a result of the reactant gas contacting the portions of the strands (46) and decomposing to form a coating of the coating material. Heating of the strands (46) can be achieved by capacitive coupling, inductive coupling, microwave radiation, and radiant heating.

## Description

### BACKGROUND OF THE INVENTION

The present invention generally relates to coating processes and equipment. More particularly, this invention relates to processes and equipment for continuously depositing coatings on fibrous materials.

Ceramic matrix composite (CMC) materials generally comprise a ceramic fiber reinforcement material embedded in a ceramic matrix material. The reinforcement material, which may be discontinuous short fibers dispersed in the matrix material or continuous fibers or fiber bundles (tows) oriented within the matrix material, serves as the load-bearing constituent of the CMC in the event of a matrix crack. In turn, the ceramic matrix protects the reinforcement material, maintains the orientation of its fibers, and serves to dissipate loads to the reinforcement material. Individual fibers (filaments) are often coated with a release agent, such as boron nitride (BN) or carbon, to form a weak interface or de-bond layer that allows for limited and controlled slip between the fibers and the ceramic matrix material. As cracks develop in the CMC, one or more fibers bridging the crack act to redistribute the load to adjacent fibers and regions of the matrix material, thus inhibiting or at least slowing further propagation of the crack.

Continuous fiber reinforced ceramic composites (CFCC) are a type of CMC that offers light weight, high strength, and high stiffness for a variety of high temperature load-bearing applications, including shrouds, combustor liners, vanes, blades, and other high-temperature components of gas turbine engines. A CFCC material is generally characterized by continuous fibers (filaments) that may be arranged to form a unidirectional array of fibers, or bundled in tows that are arranged to form a unidirectional array of tows, or bundled in tows that are woven to form a two-dimensional fabric or woven or braided to form a three-dimensional fabric. For three-dimensional fabrics, sets of unidirectional tows may, for example, be interwoven transverse to each other. As with CMCs reinforced with individual fibers, individual tows of a CFCC material can be coated with a release agent to form a de-bond layer that inhibits crack propagation.

Silicon carbide (SiC) fibers have been used as reinforcement materials for a variety of ceramic matrix materials, including SiC, titanium carbide (TiC), silicon nitride (Si₃N₄), and alumina (Al₂O₃). Of particular interest to high-temperature applications are silicon-based composites in which silicon carbide is the matrix and/or reinforcement material. A notable example is a SiC/Si-SiC (fiber/matrix) CFCC material developed by the General Electric Company under the name HiPerComp®, which contains continuous silicon carbide fibers in a matrix of silicon carbide and elemental silicon or a silicon alloy. Suitable silicon carbide fiber materials include, but are not limited to, NICALON®, HI-NICALON®, and HI-NICALON® Type S fibers commercially available from Nippon Carbon Co., Ltd., and the Tyranno family of fibers available from UBE Industries, Ltd.

Particular examples of SiC/Si-SiC CFCC materials and processes are disclosed in commonly-assigned U.S. Patent Nos. 5,015,540, 5,330,854, 5,336,350, 5,628,938, 6,024,898, 6,258,737, 6,403,158, and 6,503,441, and commonly-assigned U.S. Patent Application Publication No. 2004/0067316. As one example, SiC/Si-SiC CFCC materials can be manufactured using a filament winding process by which fibers, usually in the form of long fiber tows, are impregnated with a precursor slurry containing a matrix powder in suitable solvents and binders. Preferred compositions for the slurry will depend on the particular composition desired for the ceramic matrix. The precursor-impregnated tow is then wound onto a drum and the slurry is allowed to partially dry. The resulting prepreg is then removed from the drum, laid-up with other prepregs, and then debulked and cured while subjected to elevated pressures and temperatures to form a cured preform. The cured preform is then heated in vacuum or in an inert atmosphere to decompose the binders, yielding a porous preform that is ready for melt infiltration (MI) with molten silicon. During melt infiltration, silicon and/or one or more silicon alloys (typically applied externally to the preform) is melted and the molten silicon and/or silicon alloy infiltrates into the porosity of the preform. A portion of the molten silicon is reacted with carbon present in the preform to form silicon carbide, while any remaining molten silicon fills the porosity. Cooling yields a CMC component whose matrix comprises a silicon carbide phase and solid elemental silicon and/or one or more silicon alloy phases. Specific processing techniques and parameters for the above process will depend on the particular composition of the materials and are otherwise within the capabilities of those skilled in the art, and therefore will not be discussed here.

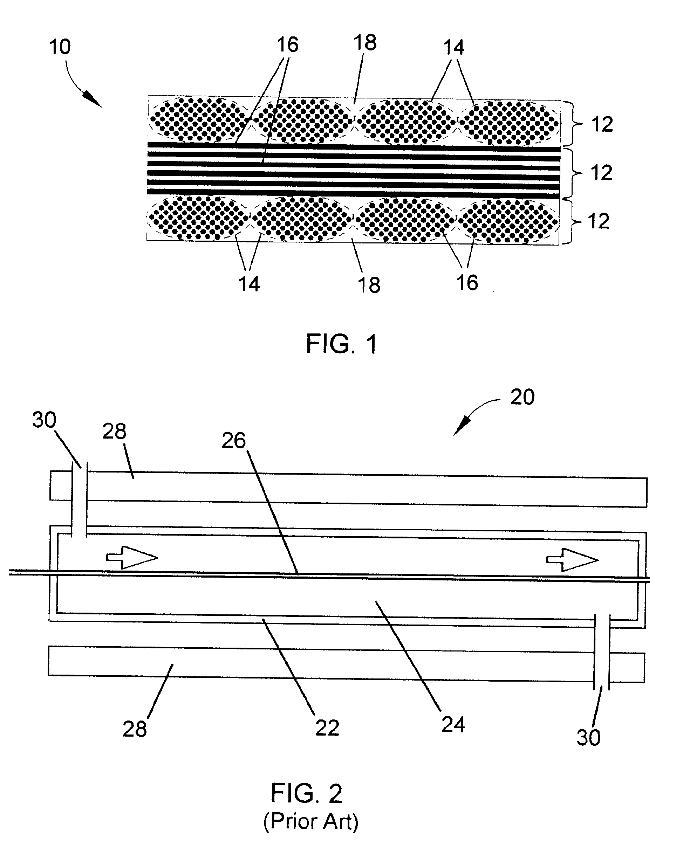

A CFCC material of a type that can be produced in accordance with the above process is schematically represented in FIG. 1. In FIG. 1, a surface region of a CFCC component 10 is represented as comprising multiple laminae 12, each derived from an individual prepreg that comprised unidirectionally-aligned tows 14 impregnated with a ceramic matrix precursor. As a result, each lamina 12 contains unidirectionally-aligned fibers 16 encased in a ceramic matrix 18 that includes silicon carbide, elemental silicon, and/or silicon alloy phases (not shown).

As previously noted, the fibers 16 are preferably coated with a weak interface or de-bond layer (not shown), typically boron nitride, carbon or mixtures thereof, which allows for limited and controlled slip between the fibers 16, tows 14, and ceramic matrix 18. Additional and/or different coatings may also be applied for various purposes, such as to protect the fibers 16 during CMC processing. A number of different techniques have been developed for applying fiber coatings, such as slurry-dipping, sol-gel, sputtering and chemical vapor deposition (CVD). Of these, CVD has been shown to be particularly well suited for producing continuous de-bond layers of uniform thickness and controlled composition. In a typical CVD process, one or more fibers or tows and a gaseous source (reactant gas) of the desired coating are heated to cause the reactant gas to decompose and deposit as a coating on the fibers or tows. CVD coatings have been applied in batch or continuous modes, the latter involving continuously passing one or more fibers or tows through a reactor containing the reactant gas, which is typically flowed through the reactor.

Nonlimiting examples of fiber coating processes of the type described above include U.S. Published Patent Application Nos. 2002/0066409 and 2007/0099527. The reactors used in such processes typically have a tubular shape through which the tows or fibers are drawn and the reactant gas flows. As represented by example in FIG. 2, a reactor 20 has a tubular housing 22 defining a fully enclosed passage or chamber 24 through which a tow (or fiber) 26 and reactant gases pass from one end to the other. The reactor 20 is a hot wall reactor, meaning that the heat necessary to warm the tow 26 and gas is supplied by a furnace 28 surrounding the housing 22. While effective, a disadvantage of this process is that, because the walls of the reactor housing 22 are heated by the furnace 28, the interior surfaces of the housing 22 are also coated at roughly the same rate as the tow 26, unnecessarily consuming some of the reactant gas. Because fiber tows often contain some fraction of broken filaments that can be released as the tow 26 travels through the reactor 20, the coating that deposits on the interior walls of the housing 22 can contain broken filaments. Build-up of the coating and broken filaments will eventually obstruct gas flow through the housing 22, necessitating shutdown and cleaning of the reactor 20.

Because the fiber coating process is typically an expensive step of the entire CMC process, reducing the cost of the coating operation can have a significant impact on the overall cost of a CMC component. Consequently, it would be desirable if coating and fiber deposition on the reactor wall could be reduced or eliminated. One such approach is to directly heat the fiber by making electrical contact with the fiber at opposite ends of the reactor, and then heating the fiber by passing a sufficiently large current through that portion of the fiber within the reactor. However, this approach is limited to some degree by the electrical conductivity of the fiber material being coated.

### BRIEF DESCRIPTION OF THE INVENTION

The present invention provides processes and apparatuses suitable for continuously depositing a coating on a fibrous material while avoiding or at least minimizing deposition of the coating on the coating apparatus.

According to a first aspect of the invention, the process is a chemical vapor deposition process that includes causing multiple strands of a fibrous material to continuously travel through a coating zone within an enclosed chamber defined by a housing so that portions of the strands contact a reactant gas as the portions travel through the chamber, directly heating the portions of the strands with a heating means that does not physically contact the strands and does not directly heat the housing, and depositing a coating material on the strands as a result of the reactant gas contacting the portions of the strands and decomposing to form a coating of the coating material. The heating step can be achieved by various non-contact techniques, including capacitive coupling, inductive coupling, microwave radiation, and radiant heating.

According to a second aspect of the invention, the apparatus includes a coating zone within an enclosed chamber defined by a housing, a device for causing strands of a fibrous material to continuously travel through the chamber, a device for contacting portions of the strands with a reactant gas as the portions of the strands travel through the chamber, and a device for directly heating the portions of the strands without physically contacting the strands and without directly heating the housing. The heating device is a capacitive coupling device, an inductive coupling device, a microwave radiation-generating device, or a radiant heating device.

In view of the above, it can be seen that a technical effect of this invention is that direct heating of a fibrous material, such as single or multiple tows (bundles of fibers/filaments) can be accomplished without making direct electrical contact with the fibrous material. Because heating is substantially limited to the fibrous material, coating deposition on the surrounding coating apparatus can be avoided or at least significantly minimized. Heating can also be achieved with fibers and tows formed of a wide variety of materials, and a wide variety of coating materials can be deposited, including those that are dielectric or an electrically insulating material. In the absence of coating buildup on the coating apparatus, it should be possible for the apparatus to operate for longer periods without need for cleaning.

Other aspects and advantages of this invention will be better appreciated from the following detailed description.

### BRIEF DESCRIPTION OF THE DRAWINGS

FIG. 1 schematically represents a fragmentary cross-sectional view of a CFCC article.

FIG. 2 schematically represents a prior art hot wall reactor for continuously depositing a coating on fibers and tows of the type used in the fabrication of the CFCC article of FIG. 1.

FIG. 3 schematically represents a reactor for continuously depositing coatings on fibers and tows by capacitively heating the fibers/tows in accordance with a particular embodiment of the present invention.

FIGS. 4 and 5 schematically represent reactors for continuously depositing coatings on fibers and tows by heating the fibers/tows with a radiant heating device without directly heating the reactor housings in accordance with additional embodiments of the present invention.

### DETAILED DESCRIPTION OF THE INVENTION

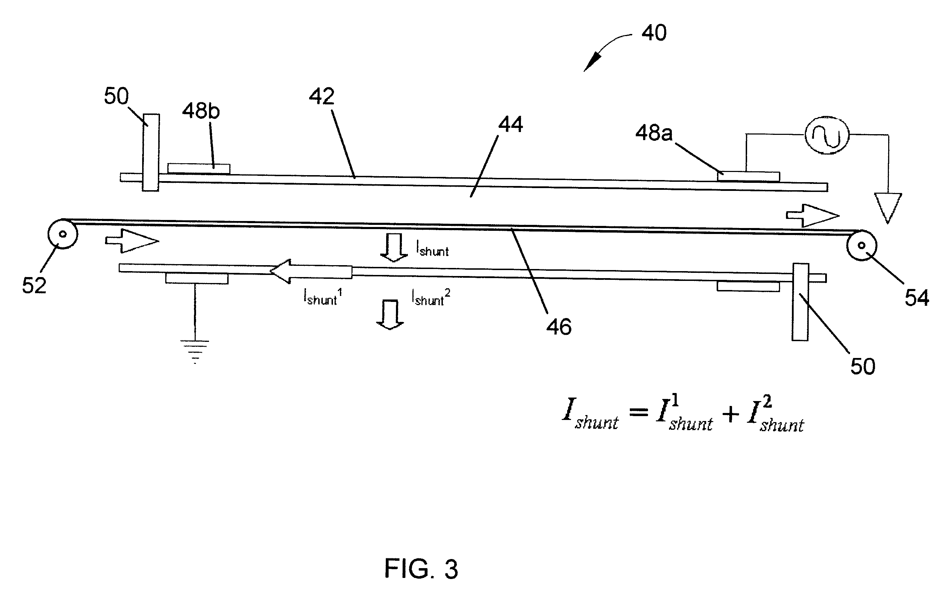

FIG. 3 schematically represents a reactor 40 adapted for continuously depositing a coating on one or more strands 46 of a fibrous material (only one strand 46 is shown in FIG. 3). The strands 46 may be of a type suitable for use as a reinforcement material in a CMC article, nonlimiting examples of which include shrouds, combustor liners, vanes, blades, and other high-temperature components of gas turbine engines. Furthermore, each strand 46 may be multiple fibers, a tow (a bundle of fibers) or multiple tows. As a particular but nonlimiting example, a strand 46 may comprise a tow containing a bundle of about four hundred to eight hundred individual fibers. For the purpose of a CMC reinforcement material, fibers within a strand 46 preferably have diameters of about 4 to about 25 micrometers, commonly about 14 micrometers, though a wide range of diameters is foreseeable. For applications in which the strands 46 is to be used as a reinforcement material in a CFCC or other CMC material, the strands 46 would be formed of a fibrous ceramic material, for example, silicon carbide or an oxide such as alumina (Al₂O₃) or mullite (3Al₂O₃•2SiO₂), though other fibrous materials are also within the scope of the invention. In addition, coatings of particular interest contain one or more release agents, nonlimiting examples of which include boron nitride (BN), silicon-doped boron nitride, silicon nitride (Si₃N₄), and carbon, to form a weak interface or de-bond layer that allows for limited and controlled slip between the strands 46 and a ceramic matrix material of a CMC. While the embodiments of the invention will be described in reference to ceramic fibrous materials suitable for use as reinforcement materials in CMC articles, other applications are also within the scope of this invention.

The reactor 40 represented in FIG. 3 is a chemical vapor deposition (CVD) apparatus that defines a coating zone through which the one or more strands 46 of fibrous material pass while contacted by a reactant gas. The reactor 40 serves to heat the strands 46 within the coating zone to a temperature and for a duration sufficient to cause decomposition of the reactant gas as the gas comes in contact with the heated strands 46. The composition of the reactant gas will depend on the composition desired for the coating. For example, if the intent is to deposit a coating containing carbon, the gas may contain or possibly consist entirely of a hydrocarbon, such as methane (CH₄). If boron nitride is an intended constituent of the coating, the gas may contain or possibly consist entirely of boron trichloride (BCl₃) and ammonia (NH₃). A silicon-doped boron nitride coating can be formed with a mixture of reactant gases that includes a silicon precursor, for example, dichlorosilane (H₂Cl₂Si), trichlorosilane (HCl₃Si), silicon tetrachloride (SiCl₄), and/or silane (SiH₄). Furthermore, a silicon nitride coating can be formed with a mixture of reactant gases that contain silicon and nitrogen precursors, for example, dichlorosilane and ammonia. The reactant gas may be accompanied by hydrogen, nitrogen or another gas that is not directly involved in the chemical deposition reaction, but is useful to dilute the reactant gas(es) to control the rate of reaction and the reaction temperature. Finally, it should be appreciated that the strands 46 can be provided with a coating containing multiple layers of different compositions, for example, by passing the strands 46 through a series of reactors that may be the same or different from the reactor 40. Those skilled in the art will appreciate that various other coating materials and structures are also possible, and therefore within the scope of the invention.

As represented in FIG. 3, the reactor 40 has an enclosed tubular housing 42 that defines a passage or chamber 44 through which the one or more strands 46 of fibrous material pass. The strands 46 are represented as being continuously transported through the housing 42 between a pair of spools 52 and 54, as is well known in the art. A reactant gas (which as used herein may be a reactant gas mixture) is introduced into the chamber 44 through one of two ports 50, while reaction byproducts and any residual reactant gas exit the housing 42 through the remaining port 50. As such, the chamber 44 defines the coating zone within the housing 42 where intimate contact occurs between the strands 46 and gas as the gas flows in the longitudinal direction of the strands 46, either in the same or opposite direction traveled by the strands 46. Within the housing 42, reactant gas pressures can range from subatmospheric to atmospheric. Chamber pressure is a variable in the CVD deposition process and influences the rate at which the gas decomposes and the mean free path of gas molecules. The cross-section of the chamber 44 may be circular, though other cross-sections are possible. Furthermore, the interior cross-sectional dimension of the housing 42 can vary, depending in part on the diameters of the strands 46. In practice, it is believed that suitable results can be obtained by spacing the interior walls of the housing 42 a distance of about 1 to about 25 centimeters from the strands 46.

In contrast to the reactor 20 of FIG. 2, the reactor 40 of FIG. 3 is not a hot wall reactor, meaning that the walls of the reactor 40 are not directly or intentionally heated for the purpose of heating the strands 46 and reactant gas within the coating zone defined by the chamber 44. In particular, the reactor 40 lacks the furnace 28 or similar device that surrounds and intentionally heats the walls of the housing 22 in FIG. 2. Instead, the walls of the housing 42 remain relatively cool so that the reactant gas is not significantly heated by the housing 42, and instead is heated and decomposed as a result of contacting the strands 46. As such, the reactor 40 avoids disadvantages associated with the reactor 20 of FIG. 2, including the tendency for coating to deposit on the interior wall surfaces of the reactor housing 42, and the build-up of coating and broken filaments that can eventually obstruct gas flow through the housing 42.

The embodiment of FIG. 3 is represented as employing an electrical capacitive coupling system capable of heating the strands 46 while avoiding direct heating of the housing 42. As schematically represented in FIG. 3, the capacitive coupling system comprises a pair of capacitive electrodes 48a and 48b (for example, plates or cylinders) adjacent opposite ends of the housing 42. Each of the electrodes 48a and 48b surrounds the housing 42 and capacitively couples with the strands 46 so as to directly heat the portion of each strand 46 that is within the housing 42 and between the electrodes 48a and 48b at any given time as the strands 46 are continuously pulled through the housing 42. Capacitive coupling is achieved by properly spacing the electrodes 48a and 48b both longitudinally along the strands 46 and radially from the strands 46, and supplying the electrodes 48a and 48b with power from a power supply at a level appropriate for the size of the housing 42 and the desired coating temperature.

The housing 42 completely circumferentially surrounds the strands 46, and thereby serves to both enclose and support the strands 46. By forming the housing 42 of an appropriate material, for example, quartz or another electrically insulating material that can withstand the reactive gas at an elevated coating temperature, the housing 42 does not interfere with capacitive coupling of the strands 46 and therefore does not interfere with heating of the strands 46. To achieve sufficient heat in the strands 46 to decompose the reactant gas, spacing of the electrodes 48a and 48b and power levels supplied to the electrodes 48a and 48b are factors, as are the materials of the housing 42 and strands 46. In addition, coating deposition rates will depend on the length of the chamber 44 (coating zone), feedrate of the strands 46, and volumetric flow rate of the reactant gas. Power, feedrate of the strands 46, and volumetric flow rate of the reactant gas can be readily adjusted as necessary for the particular reactant gas, whose composition may require a certain exposure time to the strands 46 in order to deposit a coating of suitable thickness. In practice, suitable results have been obtained with a housing formed of quartz, within which approximately one meter length of a silicon carbide tow was heated with capacitor electrodes longitudinally spaced about one meter apart, spaced about 0.5 centimeters from the tow, and connected to an alternating current source at a power level of about 360 watts. At these conditions, desired temperatures for depositing boron nitride and carbon de-bond coatings, for example, about 1000°C to about 1600°C or more, are achievable.

An additional consideration is that the deposition of coating chemistries, including boron nitride, silicon-doped boron nitride and silicon nitride, tend to produce byproducts, in other words, compounds other than the intended coating composition. A notable nonlimiting example is ammonium chloride (NH₄Cl). It will typically be desirable to avoid the deposition (condensation) of process byproducts on the strand 46 as well as on the interior wall surfaces of the reactor housing 42. Ammonium chloride deposits at a lower temperature than boron nitride, silicon-doped boron nitride and silicon nitride, and therefore deposition of this byproduct on the strands 46 can be avoided by heating the strand 46 to a temperature necessary to deposit the particular coating chemistry. However, because a preferred aspect of the invention is to intentionally avoid direct heating of the housing 42, the low temperature of the housing 42 may result in deposition of process byproducts on the interior wall surfaces of the housing 42. For this reason, it may be necessary to control the indirect heating of the interior wall surfaces of the reactor housing 42 to avoid the condensation of ammonium chloride and/or other process byproducts. More particularly, the walls of the housing 42 should be maintained at a temperature sufficiently high to avoid the condensation of process byproducts, yet sufficiently low to avoid the deposition of the intended coating constituents on the walls of the housing 42. One approach to accomplish this is to adjust (reduce) the distance between the strand 46 and the walls of the housing 42, and thereby control the indirect heating of the housing walls by the strand 46. Alternatively or in addition, various known heating devices could be used to directly heat the walls of the housing 42.

The heating techniques described above in reference to FIG. 3 do not entail heating the strands 46 by directly contacting the strands 46 with an electrical element. Other noncontact heating techniques may be employed, such as by inductively coupling the strands 46 or subjecting the strands 46 to microwave radiation or radiant heating. For example, inductive coupling can be achieved with a reactor that is similar to the housing 42 schematically represented in FIG. 3, but utilizes one or more inductive coils in place of the capacitive electrodes 48a and 48b and a housing that exhibits little or no inductive coupling with the coils. Microwave radiation can also be applied with a reactor that is similar to the housing 42 of FIG. 3, but utilizes a microwave generator in place of the capacitive electrodes 48a and 48b and a housing that does not significantly absorb microwave radiation. Notably, fibrous materials formed of silicon carbide are known to couple well to microwave radiation. In the case of microwave heating, uniform heating of the strands 46 within the chamber 44 will depend on the wavelength of the electromagnetic radiation and the design of the microwave generator/applicator. Similar to the capacitive heating technique described above, the length of the chamber 44, feedrate of the strands 46, and volumetric flow rate of the reactant gas can be adjusted as necessary for the chosen radiation frequency and the particular reactant gas.

In one investigation, multiple silicon carbide tows (HI-NICALON®) were passed through a reactor similar to that represented in FIG. 3. The housing was an approximately two inch (about five centimeters) diameter quartz tube. Instead of capacitive electrodes, the housing was surrounded by a microwave applicator designed specifically to uniformly heat an array of fiber tows with microwave radiation. The tows were transported through the housing while simultaneously passing boron trichloride and ammonia gases through the housing. Nitrogen was also passed through the housing as a diluent gas. Approximately 2 kW of microwave energy was applied to the tows, and temperatures on the surfaces of the tows of as high as about 1400°C were recorded with an optical pyrometer. A plasma was not generated, but instead the tows were directly heated by the microwave energy, and the temperature of the tows was sufficient to cause the reactant gases to decompose on the surfaces of the tows. After passing through the housing, the tows were wound onto a take-up spool. Examination by scanning microscope showed the presence of a coating having a thickness of about 220 nanometers. XPS analysis showed that the coating was BN.

In contrast to microwave heating of a single fiber, simultaneously microwave heating of multiple fibers and particularly multiple strands 46, for example, eight to twelve tows, can result in nonuniform heating of tows due to variations in the electrical properties of individual fibers and tows. A preferred aspect of this embodiment is to line the interior surfaces of the housing 42 with an infrared-reflective coating so that heat emitted from individual fibers and tows is reflected by the infrared-reflective coating back toward the strands 46, enabling hotter fibers and strands 46 to assist in heating cooler fibers and strands 46, thereby yielding more uniform heating of the strands 46 during the coating process.

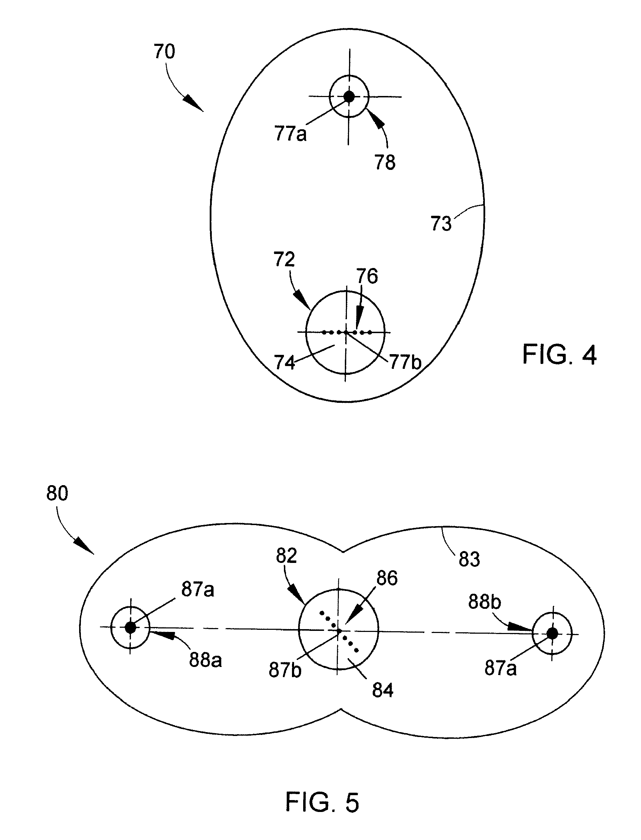

FIGS. 4 and 5 schematically represent radiant furnaces 70 and 80 that can be employed for heating and continuously depositing a coating on multiple strands 76 of fibrous material within coating chambers defined by and within housings 72 and 82, respectively. The housings 72 and 82 can be similar to the housing 42 schematically represented in FIG. 3, with the further limitation that the housings 72 and 82 must be transparent or substantially transparent to light emitted by their respective light sources 78, 88a and 88b FIG. 4 represents the radiant furnace 70 as surrounding the coating housing 72 and the light source 78, which is preferably a high intensity light source that generates electromagnetic radiation with wavelengths in the visible and infrared ranges. The coating housing 72 must be transparent or substantially transparent to light emitted by the light source 78. The radiant furnace 70 has an elliptical cross-sectional shape whose interior surface is lined with one or more optical reflectors (mirrors) 73. The light source 78 may be, for example, a tungsten/halogen lamp with a single linear filament, though other types of light sources are known and could be used. The reflectors 73 are formed of a highly reflective material, such as an anodized aluminum sheet material, though other suitable highly reflective materials are foreseeable for use as the reflectors 73. The light source 78 is located or otherwise centered at one focal point 77a of the elliptical shape of the reflectors 73, and the housing 72 is located or otherwise centered at the second focal point 77b of the elliptical shape, such that the reflectors 73 focus the light generated by the light source 78 at the first focal point 77a onto the strands 76 located within the housing chamber 74 at the second focal point 77b. A reactant gas can then be introduced into the chamber 74 and reaction byproducts and any residual reactant gas can be withdrawn from the chamber 74 through ports (not shown) similar to what is described for the previous embodiments. The longitudinal length of the radiant furnace 70 is preferably equal to the length of the light source 78.

The radiant furnace 80 of FIG. 5 can be used if the single light source 78 of FIG. 4 does not provide sufficient energy to heat the strands 76 to a desired temperature. FIG. 5 represents the radiant furnace 80 as surrounding the coating housing 82 and two high intensity light sources 88a and 88b on opposite sides of the housing 82. The radiant furnace 70 has a cross-sectional shape defined by two intersecting ellipses that define two separate focal points 87a and share a common focal point 87b. As with the embodiment of FIG. 4, the interior surface of the radiant furnace 80 is lined with one or more optical reflectors (mirrors) 83. The reflectors 83 are arranged so that the light sources 88a and 88b are located or otherwise centered at the focal points 87a of each elliptical shape, and the coating housing 82 is located or otherwise centered at the coinciding focal point 87b of the intersecting elliptical shapes. As such, the reflectors 83 lining the interior surface of the radiant furnace 80 focus the light generated by the light sources 78 located at the focal points 87a onto the strands 86 located within the housing chamber 84 at the coinciding focal point 87b. A reactant gas is introduced and reaction byproducts and any residual reactant gas are withdrawn from the chamber 84 through ports (not shown), similar to what is described for the previous embodiments. The strands 86 are represented as being aligned in a linear array whose midpoint is located at the coinciding focal point 87b. Alternatively, the strands 86 could be arranged in a different pattern, such as a circular pattern whose axis is located at the focal point 87c, for example, to promote more uniform heating of the strands 86.

A radiant furnace capable of precisely focusing the light energy generated by the light sources 78, 88a and 88b will generally define a heated zone that is roughly the same size as the filaments of lamps used as the light sources 78, 88a and 88b. It should be apparent that suitable light sources are not limited to a linear shape, in that any light source shape can be focused onto the linear strands 76 and 86 by using properly designed optics. In addition, a furnace could be configured to accommodate different numbers of light sources, each with its own elliptical reflector that shares a common second focal point with the other reflectors. Uniform heating of multiple strands 76 and 86 may be further promoted by defocusing the focal points 77b and 87b of the light sources 78, 88a and 88b by locating the light sources 78, 88a and 88b slightly away from the focal points 77a and 87a, so that the radiation energy generated by the light sources 78, 88a and 88b is focused over a wider cross-sectional area within the housings 72 and 82.

Whereas microwave heating and induction heating depend on electrical conductivity of the fiber material of the strands 46, the radiant furnaces 70 and 80 depend on fiber emissivity for heating, allowing for the heating of a wider variety of fiber materials. Most notably, in addition to electrically conductive fibers such as silicon carbide, non-conductive fibers can be heated by this technique, such as alumina or mullite, as long as the fiber material absorbs energy emitted by the light source(s) 78 or 88a and 88b.

In another investigation, multiple silicon carbide tows (HI-NICALON®) were passed through a furnace of the type represented in FIG. 5. The housing was an approximately two inch (about five centimeters) diameter quartz tube. The tows were transported through the housing while simultaneously passing boron trichloride and ammonia gases through the housing. Nitrogen was also passed through the housing as a diluent gas. The housing was approximately the same length as the light sources, which were two commercial 2 kW quartz/halogen lamps having lengths of about ten inches (about twenty-five centimeters). Each lamp had an elliptical reflector, and the elliptical reflectors shared a common second focal point. The tows were transported through the housing at the shared second focal point and at a speed of about four inches/minute (about ten centimeters per minute) while passing boron trichloride and ammonia gases at the same time. Nitrogen was used as diluent gas. After passing through the housing, the tows were wound onto a take-up spool. Examination of the tows by scanning microscope showed presence of a coating having a thickness of about 250 nanometers thick. XPS analysis showed the coating to be BN.

Following coating of the strands 46, 76 and 86 using reactors of the types represented in FIGS. 3 through 5, the strands 46, 76 and 86 can be wound onto a spool (54 in FIG. 3) for later unspooling and use as a reinforcement material in a CMC process to produce a CMC article, especially a CFCC article. For example, suitable CMC processes include those described above, including those disclosed in U.S. Patent Nos. 5,015,540, 5,330,854, 5,336,350, 5,628,938, 6,024,898, 6,258,737, 6,403,158, and 6,503,441, and U.S. Patent Application Publication No. 2004/0067316.

While the invention has been described in terms of specific embodiments, it is apparent that other forms could be adopted by one skilled in the art. For example, the physical configuration of the reactors could differ from that shown, and materials and processes other than those noted could be used. Therefore, the scope of the invention is to be limited only by the following claims.

Various aspects of the present invention are defined by the following numbered clauses:
1. A chemical vapor deposition process comprising:
   causing multiple strands of a fibrous material to continuously travel through a coating zone within an enclosed chamber defined by a housing so that portions of the strands contact a reactant gas as the portions travel through the chamber;
   directly heating the portions of the strands with a heating means that does not physically contact the strands and does not directly heat the housing, the heating means being chosen from the group consisting of capacitive or inductive coupling means, microwave radiation-generating means, and radiant heating means;
   depositing a coating material on the strands as a result of the reactant gas contacting the portions of the strands and decomposing to form a coating of the coating material.
2. The chemical vapor deposition process according to clause 1, wherein the portions of the strands are heated by the capacitive coupling means.
3. The chemical vapor deposition process according to clause 2, wherein the capacitive coupling means comprises capacitor electrodes.
4. The chemical vapor deposition process according to clause 3, wherein the housing is surrounded by the capacitor electrodes.
5. The chemical vapor deposition process according to clause 1, wherein the portions of the strands are heated by the microwave radiation-generating means and microwave radiation generated thereby.
6. The chemical vapor deposition process according to clause 5, wherein the housing is surrounded by the microwave radiation-generating means.
7. The chemical vapor deposition process according to clause 6, further comprising an infrared-reflective coating on an interior surface of the housing, the infrared-reflective coating being adapted to reflect heat emitted from the strands back toward the strands.
8. The chemical vapor deposition process according to clause 1, wherein the portions of the strands are heated by the radiant heating means and electromagnetic radiation generated thereby.
9. The chemical vapor deposition process according to clause 8, wherein the housing is surrounded by the radiant heating means.
10. The chemical vapor deposition process according to clause 9, further comprising an optical reflector that contains the housing and the radiant heating means.
11. The chemical vapor deposition process according to clause 10, wherein the optical reflector has an elliptical cross-section, the radiant heating means is located at a first focal point of the elliptical cross-section, and the housing is located at a second focal point of the elliptical cross-section.
12. The chemical vapor deposition process according to clause 10, wherein the optical reflector has a cross-section defined by at east two intersecting ellipses, each of the ellipses individually has a first focal point, the ellipses share a coinciding second focal point, the radiant heating means is located at each of the first focal points, and the housing is located at the coinciding second focal point.
13. The chemical vapor deposition process according to clause 1, wherein the strands comprise a plurality of tows of ceramic fibers, and the coating material is a de-bond layer that inhibits bonding of the ceramic fibers to a ceramic material.
14. The chemical vapor deposition process according to clause 1, wherein the coating material is chosen from the group consisting of boron nitride, silicon-doped boron nitride, silicon nitride, and carbon.
15. The chemical vapor deposition process according to clause 14, the process further comprising intentionally heating the housing to a temperature that is sufficiently high to inhibit deposition of process byproducts on the housing and sufficiently low to inhibit deposition of the coating material on the housing.
16. The chemical vapor deposition process according to clause 14, further comprising using the coated strands produced by the depositing step as a reinforcement material in a ceramic matrix composite material.
17. A chemical vapor deposition apparatus comprising:
   a coating zone within an enclosed chamber defined by a housing;
   means for causing multiple strands of a fibrous material to continuously travel through the chamber;
   means for contacting portions of the strands with a reactant gas as the portions of the strands travel through the chamber; and
   means for directly heating the portions of the strands without physically contacting the strands and without directly heat the housing, the heating means being chosen from the group consisting of capacitive and inductive coupling means, microwave radiation-generating means, and radiant heating means.
18. The chemical vapor deposition apparatus according to clause 17, wherein the portions of the strands are heated by the microwave radiation-generating means and microwave radiation generated thereby.
19. The chemical vapor deposition apparatus according to clause 17, wherein the portions of the strands are heated by the radiant heating means and electromagnetic radiation generated thereby, the chemical vapor deposition apparatus further comprising an optical reflector that contains the chamber and the radiant heating means, the optical reflector has an elliptical cross-section, the radiant heating means is located at a first focal point of the elliptical cross-section, and the coating zone is located at a second focal point of the elliptical cross-section.
20. The chemical vapor deposition apparatus according to clause 17, wherein the portions of the strands are heated by the radiant heating means and electromagnetic radiation generated thereby, the chemical vapor deposition apparatus further comprising an optical reflector that contains the chamber and the radiant heating means, the optical reflector has a cross-section defined by at least two intersecting ellipses, each of the ellipses individually has a first focal point, the ellipses share a coinciding second focal point, the radiant heating means is located at each of the first focal points, and the coating zone is located at the coinciding second focal point.

## Claims

1. A chemical vapor deposition process comprising causing multiple strands (46,76,86) of a fibrous material to continuously travel through a coating zone within an enclosed chamber (44,74,84) defined by a housing (42,72,82) so that portions of the strands (46,76,86) contact a reactant gas as the portions travel through the chamber (44,74,84), and depositing a coating material on the strands (46,76,86) as a result of the reactant gas contacting the portions of the strands (46,76,86) and decomposing to form a coating of the coating material, **characterized by**:
directly heating the portions of the strands (46,76,86) with a heating means (48a,48b,78,88a,88b) that does not physically contact the strands (46,76,86) and does not directly heat the housing (42,72,82), the heating means (48a,48b,78,88a,88b) being chosen from the group consisting of capacitive or inductive coupling means (48a,48b), microwave radiation-generating means (48a,48b), and radiant heating means (78,88a,88b).

2. The chemical vapor deposition process according to claim 1, **characterized in that** the portions of the strands (46,76,86) are heated by the microwave radiation-generating means (48a,48b) and microwave radiation generated thereby.

3. The chemical vapor deposition process according to claim 2, further **characterized by** an infrared-reflective coating on an interior surface of the housing (42), the infrared-reflective coating being adapted to reflect heat emitted from the strands (46) back toward the strands (46).

4. The chemical vapor deposition process according to claim 1, **characterized in that** the portions of the strands (46,76,86) are heated by the radiant heating means (78,88a,88b) and electromagnetic radiation generated thereby.

5. The chemical vapor deposition process according to claim 4, further **characterized by** an optical reflector (73,83) that contains the housing (72,82) and the radiant heating means (78,88a,88b).

6. The chemical vapor deposition process according to claim 5, **characterized in that** the optical reflector (73) has an elliptical cross-section, the radiant heating means (78) is located at a first focal point (77a) of the elliptical cross-section, and the housing (72) is located at a second focal point (77b) of the elliptical cross-section.

7. The chemical vapor deposition process according to claim 5, **characterized in that** the optical reflector (83) has a cross-section defined by at east two intersecting ellipses, each of the ellipses individually has a first focal point (87a), the ellipses share a coinciding second focal point (87b), the radiant heating means (88a,88b) is located at each of the first focal points (87a), and the housing (82) is located at the coinciding second focal point (87b).

8. The chemical vapor deposition process according to any one of claims 1 to 7, **characterized in that** the coating material is a de-bond layer that inhibits bonding of the fibrous material to a ceramic material.

9. The chemical vapor deposition process according to any one of claims 1 to 8, further **characterized by** using the coated strands produced by the depositing step as a reinforcement material in a ceramic matrix composite material.

10. A chemical vapor deposition apparatus (50,70,80) adapted to perform the process of any one of claims 1 to 9.
